# FASCICULE DE BREVET EUROPEEN

(11) **EP 1 568 130 B1**
(45) Date de publication et mention de la délivrance du brevet: **28.02.2007**
(21) Numéro de dépôt: 03767907.3
(22) Date de dépôt: 05.11.2003
(51) Int. Cl.: H03J 7/04, H03J 1/00

(54) **CIRCUIT D'ANTENNE ACCORDABLE, NOTAMMENT POUR LECTEUR DE CIRCUIT INTEGRE SANS CONTACT**
ABSTIMMBARE ANTENNENSCHALTUNG, INSBESONDERE FÜR EIN KONTAKTLOSES INTEGRIERTES LESEGERÄT
TUNABLE ANTENNA CIRCUIT, PARTICULARLY FOR A WIRELESS INTEGRATED CIRCUIT READER

(30) Priorité: 12.11.2002 FR 0214127
(43) Date de publication de la demande: 31.08.2005
(73) Titulaire: Inside Contactless, 13856 Aix en Provence Cedex 3 (FR)
(72) Inventeur: CHARRAT, Bruno, F-13090 Aix en Provence (FR)
(74) Mandataire: Marchand, André
(86) Numéro de dépôt international: PCT/FR2003/003295
(87) Numéro de publication internationale: WO 2004/045074

(56) Documents cités:
- EP-A- 0 663 724
- DE-A- 19 546 928
- DE-A- 19 755 250
- US-A- 6 028 503
- US-A- 6 070 803

## Description

La présente invention concerne les circuits d'antenne inductifs, notamment pour lecteurs de circuit intégré sans contact.

La présente invention concerne plus particulièrement un circuit d'antenne accordable sur une fréquence de résonance déterminée, comprenant une bobine d'antenne et des composants ajustables.

La présente invention concerne également un procédé pour accorder un tel circuit d'antenne.

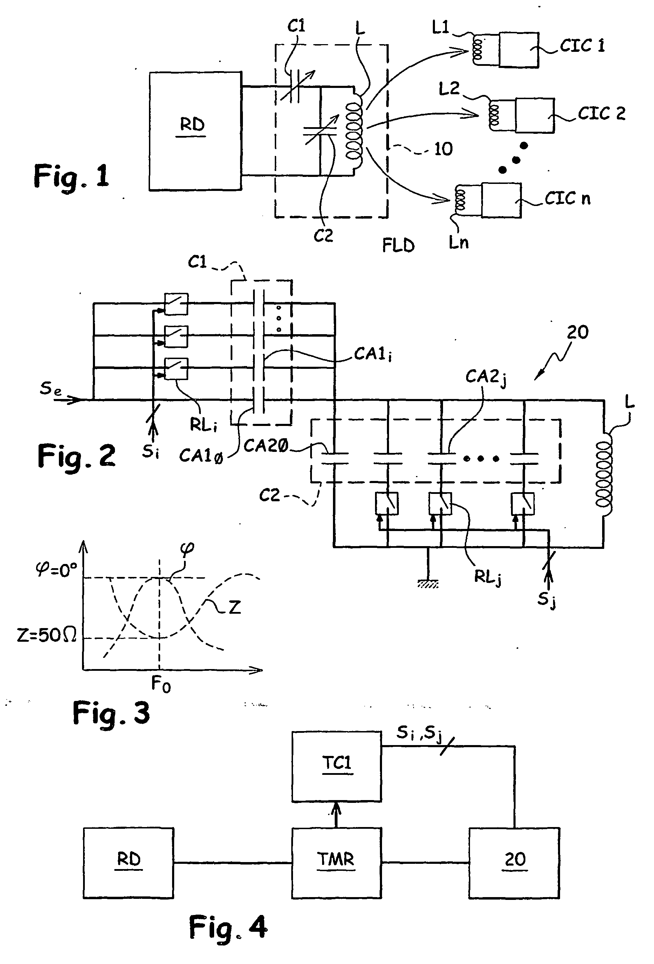

La figure 1 représente schématiquement un lecteur de circuit intégré sans contact RD équipé d'un circuit d'antenne 10 du type précité. Le circuit d'antenne 10 comprend une bobine L et des composants ajustables, ici deux capacités ajustables CA1, CA2. Le circuit d'antenne reçoit un signal d'excitation alternatif Se de fréquence F0 fourni par le lecteur RD, et émet un champ magnétique alternatif FLD. Ce champ magnétique permet au lecteur RD de communiquer par couplage inductif avec des circuits intégrés sans contact CIC1, CIC2... CICn équipés eux-mêmes d'une bobine d'antenne L1, L2,... Ln. Les circuits intégrés CIC1-CICn sont par exemple des circuits intégrés de cartes à puce sans contact, des circuits intégrés d'étiquettes électroniques sans contact ("tags"), des circuits intégrés de badges sans contact, etc..

Les capacités ajustables CA1, CA2 permettent d'accorder la fréquence de résonance du circuit d'antenne sur la fréquence F0 du signal d'excitation, qui est par exemple de 13,56 MHz selon les normes ISO 15693 et ISO 14443. L'accord du circuit d'antenne sur la fréquence F0 permet d'obtenir une distance de communication optimale entre le lecteur et les circuits intégrés sans contact.

Bien que cet accord soit généralement réalisé au moment de la mise en service du circuit d'antenne, celui-ci est ensuite soumis à des variations d'humidité et de température qui peuvent dérégler sensiblement sa fréquence de résonance. La présence d'objets métalliques à proximité du circuit d'antenne exerce également une influence sur la fréquence de résonance. Le circuit d'antenne doit ainsi être accordé à nouveau sur site pour tenir compte des conditions d'utilisation. Il doit ensuite être accordé à intervalles réguliers si l'on souhaite que le lecteur RD présente une distance de communication optimale.

L'accord du circuit d'antenne peut être réalisé manuellement mais cette solution nécessite l'intervention d'un personnel qualifié. De plus, un accord manuel peut s'avérer difficile dans certaines conditions d'utilisation. Considérons à titre d'exemple un lecteur de badges sans contact dédié au contrôle d'accès dans des équipements de transport en haute montagne (télésièges, téléphériques...). En raison des mauvaises conditions météorologiques et des températures très basses, il est difficile d'ajuster les composants du circuit d'antenne à main nue, au moyen d'un tournevis.

On prévoit dans ce cas un circuit d'antenne accordable électriquement comprenant un équipement embarqué assurant automatiquement l'accord du circuit d'antenne ("autotuning"), par exemple une fois par jour. L'exemple d'un tel circuit est divulgué par le document US-A-6 070 603.

La figure 2 représente un circuit d'antenne 20 accordable électriquement, comprenant à cet effet des capacités CA1, CA2 ajustables électriquement. La capacité CA1 comprend une capacité CA1₀ en parallèle avec une pluralité de capacités commutables CA1ᵢ. La capacité CA2 comprend une capacité CA2₀ en parallèle avec une pluralité de capacités commutables CA2ⱼ. Chaque capacité CA1ᵢ, respectivement CA2ⱼ est commutable au moyen d'un relais électrique RLᵢ, respectivement RLⱼ, agencé en série avec la capacité. Les relais RLᵢ sont pilotés par des signaux Sᵢ et les relais RLⱼ sont pilotés par des signaux Sⱼ. Ainsi, la combinaison de signaux Sᵢ détermine la valeur de la capacité CA1 et la combinaison de signaux Sⱼ détermine la valeur de la capacité CA2.

La figure 3 représente des courbes de phase ϕ et d'impédance Z du circuit d'antenne 20 lorsque celui-ci reçoit un signal d'excitation Se oscillant à la fréquence F0, par exemple 13,56 MHz.

L'accord du circuit d'antenne sur la fréquence F0 consiste en théorie à trouver un couple de valeurs déterminées de l'impédance Z et de la phase ϕ, généralement Z=50Ω et ϕ=0°.

Toutefois, un matériel de mesure de la phase ϕ et de l'impédance Z est généralement trop coûteux et encombrant pour former un matériel embarqué.

Ainsi, comme illustré sur la figure 4, le matériel embarqué assurant l'accord automatique du circuit d'antenne comprend généralement un simple tosmètre TMR agencé entre le circuit d'antenne 20 et le lecteur RD, et un dispositif d'accord TC1 fournissant les signaux Sᵢ, Sⱼ de commande des relais du circuit d'antenne. Le tosmètre mesure le taux d'ondes stationnaires et le dispositif TC1 accorde le circuit d'antenne de manière que le taux d'ondes stationnaires soit minimal à la fréquence F0.

Cette méthode d'accord est simple et peu coûteuse mais souffre toutefois d'une précision médiocre. Le taux d'ondes stationnaires forme en effet une indication qui, bien qu'étant pertinente, peut être considérée à la lumière de l'expérience acquise comme insuffisante à elle seule pour l'obtention d'un accord fiable et précis. De plus, un ajustage du circuit d'antenne basé sur le taux d'ondes stationnaires est long et difficile à trouver. De nombreuses combinaisons des signaux Si, Sj doivent être testées avant de trouver la combinaison présumée optimale.

Ainsi, la présente invention vise un procédé d'accord d'un circuit d'antenne qui soit plus précis que le procédé classique décrit ci-dessus.

La présente invention vise notamment un procédé d'accord qui soit précis et qui puisse notamment être mis en oeuvre par un matériel embarqué simple à réaliser et d'un prix de revient réduit.

La présente invention vise également un circuit d'antenne qui soit simple à accorder.

Pour atteindre ces objectifs, l'idée de la présente invention est d'intégrer dans un circuit d'antenne un filtre ou un déphaseur aux bornes duquel apparaît une tension dont l'amplitude forme une indication pertinente pouvant être exploitée pour accorder avec précision le circuit d'antenne, lorsque l'amplitude du signal d'excitation est connue. Si l'amplitude du signal d'excitation n'est pas connue, la présente invention prévoit de mesurer deux tensions aux bornes du filtre et d'accorder le circuit d'antenne de manière que ces deux tensions présente un rapport d'amplitude et une différence de phase déterminées.

Plus particulièrement, la présente invention prévoit un circuit d'antenne accordable sur une fréquence de résonance déterminée, comprenant une bobine d'antenne et des composants ajustables, ainsi qu'un un filtre faisant partie intégrante du circuit d'antenne et présentant au moins un point de prélèvement d'une tension électrique dont l'amplitude forme une information pertinente pour l'accord du circuit d'antenne.

Selon un mode de réalisation, le filtre est agencé à l'entrée du circuit d'antenne.

Selon un mode de réalisation, le filtre présente une structure en π.

Selon un mode de réalisation, le filtre est un élément LC.

Selon un mode de réalisation, le filtre comprend une inductance série et deux capacités en parallèle.

Selon un mode de réalisation, le circuit d'antenne comprend un circuit de mesure embarqué connecté au filtre au moins au point de prélèvement de la tension électrique.

Selon un mode de réalisation, filtre présente deux points de prélèvement de deux tensions électriques dont le rapport d'amplitude forme une information pertinente pour l'accord du circuit d'antenne.

Selon un mode de réalisation, le circuit d'antenne comprend un circuit de mesure embarqué connecté aux deux points de prélèvement des deux tensions électriques.

Selon un mode de réalisation, le circuit de mesure comprend des moyens de mesure d'amplitude fournissant deux signaux en tension ou en courant continu proportionnels à l'amplitude des tensions électriques.

Selon un mode de réalisation, le circuit de mesure comprend des moyens de mesure de la différence de phase entre les deux tensions électriques.

Selon un mode de réalisation, les moyens de mesure de la différence de phase fournissent un signal en tension ou en courant continu qui est proportionnel à la différence de phase entre les deux tensions électriques.

Selon un mode de réalisation, les moyens de mesure de la différence de phase comprennent une porte logique recevant en entrée des signaux issus des deux tensions électriques, et des moyens pour fournir un signal en tension ou en courant continu proportionnel au rapport cyclique d'un signal fourni par la porte logique.

Selon un mode de réalisation, le circuit d'antenne comprend un dispositif d'accord embarqué agencé pour ajuster les composants ajustables du circuit d'antenne de manière que les deux tensions électriques présentent un rapport d'amplitude déterminé.

Selon un mode de réalisation, le dispositif d'accord est agencé pour ajuster les composants ajustables du circuit d'antenne de manière que les deux tensions électriques aient la même amplitude.

Selon un mode de réalisation, le dispositif d'accord embarqué est agencé pour ajuster les composants ajustables du circuit d'antenne de manière que les deux tensions électriques présentent également une différence de phase déterminée.

Selon un mode de réalisation, le dispositif d'accord est agencé pour ajuster les composants ajustables du circuit d'antenne de manière que les deux tensions électriques présentent une différence de phase de 90°.

Selon un mode de réalisation, le dispositif d'accord comprend un microprocesseur recevant un premier signal représentatif de l'amplitude de l'une des deux tensions électriques, un second signal représentatif de l'amplitude de l'autre tension électrique, et un troisième signal représentatif de la différence de phase entre les deux tensions électriques, le microprocesseur fournissant au circuit d'antenne des signaux de contrôle des composants ajustables.

Selon un mode de réalisation, pendant l'accord du circuit d'antenne par le dispositif d'accord, le circuit d'antenne reçoit un signal d'excitation fourni par un lecteur de circuit intégré sans contact.

Selon un mode de réalisation, les composants ajustables comprennent des capacités commutables électriquement.

Selon un mode de réalisation, le circuit d'antenne comprend des composants ajustables comportant chacun une capacité, une diode connectée à la cathode de la capacité, et un transistor interrupteur pour appliquer ou ne pas appliquer une tension de polarisation à l'anode de la diode, de manière que la capacité soit active ou inactive dans le circuit d'antenne.

La présente invention concerne également un lecteur circuit intégré sans contact, comprenant un circuit d'antenne selon l'invention.

La présente invention concerné également un procédé pour accorder sur une fréquence de résonance déterminée un circuit d'antenne comprenant une bobine d'antenne et des composants ajustables, comprenant les étapes consistant à : incorporer un filtre dans le circuit d'antenne de manière que le filtre fasse partie intégrante du circuit d'antenne; appliquer un signal d'excitation au circuit d'antenne; prélever au moins une première tension électrique sur une borne du filtre ; ajuster les composants ajustables du circuit d'antenne de manière que la première tension électrique présente une

Selon un mode de réalisation, le procédé comprend les étapes consistant à : prélever une deuxième tension électrique sur une autre borne du filtre ; ajuster les composants ajustables du circuit d'antenne de manière que les deux tensions électriques présentent un rapport d'amplitude déterminé.

Selon un mode de réalisation, les composants ajustables du circuit d'antenne sont ajustés de manière que les deux tensions électriques aient la même amplitude.

Selon un mode de réalisation, les composants ajustables du circuit d'antenne sont ajustés de manière que les deux tensions électriques présentent également une différence de phase déterminée.

Selon un mode de réalisation, les composants ajustables du circuit d'antenne sont ajustés de manière que les deux tensions électriques présentent une différence de phase de 90°.

Selon un mode de réalisation, les deux tensions électriques sont mesurées au moyen d'un circuit de mesure embarqué relié au filtre de façon permanente.

Selon un mode de réalisation, le filtre est agencé à l'entrée du circuit d'antenne.

Selon un mode de réalisation, le filtre présente une structure en π.

Selon un mode de réalisation, le filtre est un élément LC.

Selon un mode de réalisation, le filtre comprend une inductance série et deux capacités en parallèle.

Selon un mode de réalisation, l'accord du circuit d'antenne est réalisé au moyen d'un dispositif d'accord embarqué relié au filtre de façon permanente.

Selon un mode de réalisation, l'accord du circuit d'antenne est réalisé au moyen d'un dispositif d'accord embarqué comprenant un microprocesseur programmé pour accorder cycliquement le circuit d'antenne.

Selon un mode de réalisation, le circuit d'antenne reçoit pendant son accord un signal d'excitation fourni par un lecteur de circuit intégré sans contact.

Selon un mode de réalisation, les composants ajustables du circuit d'antenne comprennent des capacités commutables électriquement.

Selon un mode de réalisation, l'accord du circuit d'antenne est réalisé au moyen de composants ajustables comprenant chacun une capacité, une diode connectée à la cathode de la capacité, et un transistor interrupteur pour appliquer ou ne pas appliquer une tension de polarisation à l'anode de la diode, de manière que la capacité soit active ou inactive dans le circuit d'antenne.

Ces objets, caractéristiques et avantages ainsi que d'autres de la présente invention seront exposés plus en détail dans la description suivante du procédé selon l'invention et d'un circuit d'antenne selon l'invention, faite à titre non limitatif en relation avec les figures jointes parmi lesquelles :
- la figure 1 précédemment décrite représente schématiquement un lecteur sans contact équipé d'un circuit d'antenne accordable,
- la figure 2 précédemment décrite représente un circuit d'antenne accordable comprenant des composants ajustables électriquement,
- la figure 3 précédemment décrite représente des courbes de phase et d'impédance d'un circuit d'antenne,
- la figure 4 précédemment décrite représente un circuit d'antenne classique pourvu d'un dispositif d'accord automatique,
- la figure 5 représente un lecteur sans contact comportant un circuit d'antenne selon l'invention et un dispositif d'accord automatique selon l'invention,
- la figure 6 est le schéma électrique d'un circuit de mesure représenté sous forme de bloc en figure 5,
- la figure 7 est le schéma électrique d'un autre circuit de mesure représenté sous forme de bloc en figure 5,
- les figures 8A à 8D sont des chronogrammes de signaux électriques illustrant le fonctionnement du circuit de mesure de la figure 7,
- la figure 9 est le schéma d'un composant ajustable selon l'invention,
- les figures 10A et 10B sont des courbes illustrant le fonctionnement du composant ajustable de la figure 9.

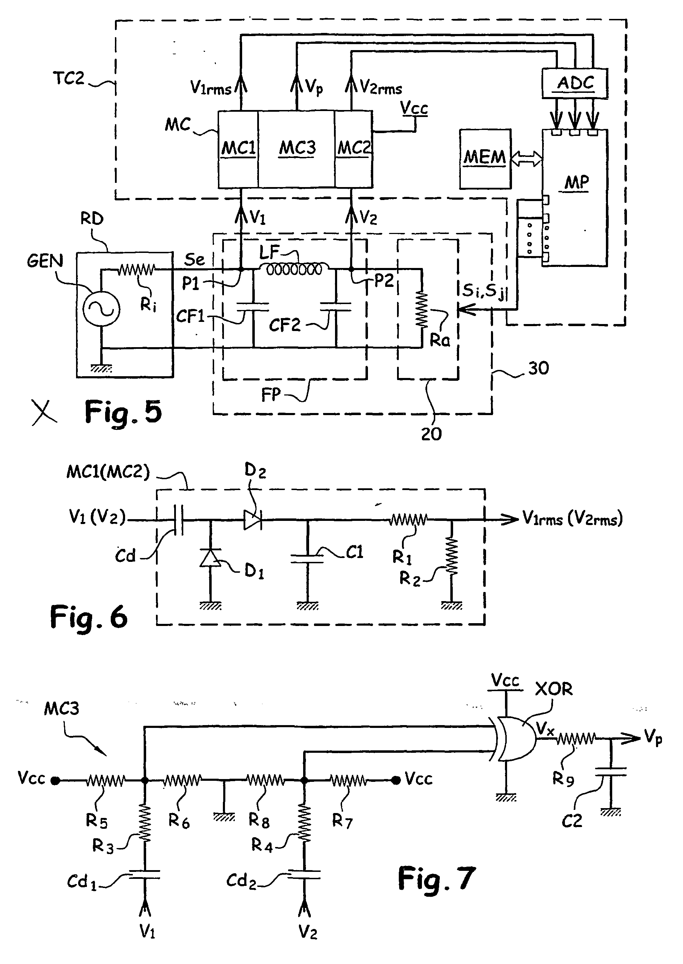

La figure 5 représente un lecteur RD de circuit intégré sans contact comprenant un circuit d'antenne 30 selon l'invention et un dispositif d'accord embarqué TC2. Le circuit d'antenne 30 et le dispositif d'accord TC2 peuvent être réalisés sur un même support, par exemple une même plaquette de circuit imprimé. Ils forment alors un circuit d'antenne global intégrant des moyens d'accord automatique du circuit d'antenne proprement dit.

Le circuit d'antenne 30 selon l'invention comprend un circuit d'antenne 20 et un filtre FP. Le circuit d'antenne 20 est un circuit d'antenne accordable électriquement comprenant des composants ajustables électriquement. Sa structure est par exemple celle du circuit d'antenne décrit plus haut en relation avec la figure 2, dont les références sont conservées. Le circuit d'antenne 20 est représenté ici accordé, sous la forme d'une résistance pure Ra de 50Ω.

Le filtre FP est connecté ici à l'entrée du circuit d'antenne 20 et fait partie intégrante du circuit d'antenne 30, l'entrée du filtre FP formant l'entrée du circuit d'antenne 30. Un signal d'excitation Se est appliqué au circuit d'antenne 30, soit à l'entrée du filtre FP, et est transmis au circuit d'antenne 20 via le filtre FP.

Dans un souci de clarté, on appellera par la suite "sous-circuit d'antenne" le circuit d'antenne 20, afin de le distinguer du circuit d'antenne 30.

Le filtre FP est ici un filtre en π comprenant une self série LF et deux capacités CF1, CF2. De façon générale, on désigne par "capacité X" (X étant par exemple CF1 ou CF2) un condensateur dont la capacité est égale à X ou un groupe de condensateurs en série et/ou en parallèle formant une capacité résultante de valeur X.

Le signal d'excitation Se est ici fourni par un lecteur RD de circuit intégré sans contact, comprenant un générateur GEN de signal alternatif ayant une résistance interne série Ri de 50Ω.

On suppose ici que le circuit d'antenne selon l'invention est destiné à des lecteurs d'origine diverses dont les caractéristiques électriques ne sont pas constantes, et l'on considère donc ici que l'amplitude nominale Vnom du signal d'excitation Se n'est pas connue. L'amplitude nominale Vnom est l'amplitude du signal Se lorsque le générateur GEN est relié à une charge standard, généralement 50Ω.

Dans ces conditions, le dispositif d'accord TC2 est relié au filtre FP en deux points P1, P2 de prélèvement de deux tensions V1, V2, situés à l'entrée du filtre FP (soit l'entrée du circuit d'antenne 30) et à la sortie du filtre FP (soit l'entrée du sous-circuit d'antenne 20). Le point P1 est ainsi situé ici sur une borne de l'inductance LF et sur l'anode de la capacité CF1 et le point P2 situé sur l'autre borne de l'inductance LF et sur l'anode de la capacité CF2.

Selon l'invention, les capacités CF1, CF2 et l'inductance LF sont déterminées lors de la conception du circuit d'antenne 30 de la manière suivante:
1) le sous-circuit d'antenne 20 est accordé sur la fréquence de résonance souhaitée, par exemple 13,56 MHz, et présente alors une impédance d'entrée ZO et une phase ϕ0 déterminées, généralement 50Ω et 0°,
2) le filtre FP est combiné au sous-circuit d'antenne 20 pour former le circuit d'antenne 30 selon l'invention, et les valeurs de CF1, CF2, LF sont ensuite déterminées par calcul théorique et/ou par des expérimentations. Les valeurs de CF1, CF2, LF sont telles que le circuit d'antenne 30 présente toujours, vu de son entrée, une impédance Z0 de 50Ω et une phase ϕ0 de 0° malgré la présence du filtre.

Selon les études conduites par la demanderesse, les valeurs de CF1, CF2, LF pour une fréquence de F0 de 13,56 MHz sont par exemple :
CF1=CF2=220 pF
LF=560 nH

Le filtre FP est alors un filtre passe bas ayant une fréquence de coupure supérieure à la fréquence d'accord visée F0, ici 13,56 MHz.

Après avoir déterminé CF1, CF2, LF, on mesure le rapport d'amplitude et la différence de phase entre les tensions V1 et V2 à l'entrée et à la sortie du filtre FP, toujours à la fréquence visée F0. Avec un filtre en π, on constate que l'amplitude de V1 est égale à l'amplitude de V2 et que la différence de phase entre ces deux tensions est de 90°.

Une fois les valeurs CF1, CF2, LF trouvées, ainsi que les rapports d'amplitude et la différence de phase entre V1 et V2, le filtre FP peut être fabriqué industriellement, de préférence avec des composants de qualité, et peut être intégré dans tous les circuits d'antenne 30 selon l'invention qui sont commercialisés et qui comportent des sous-circuits d'antenne 20 de même structure.

Lorsque le circuit d'antenne 30 n'est pas accordé à fréquence visée, ici 13,56 MHz, on trouve aux bornes du filtre FP des tensions V1 et V2 ayant des amplitudes différentes et une différence de phase qui n'est pas égale à 90°. Dans ce cas l'accord du circuit d'antenne 30 peut être obtenu simplement en ajustant les composants du sous-circuit d'antenne 20 de manière que l'amplitude de V1 devienne égale à l'amplitude de V2 et que la différence de phase entre ces deux tensions devienne égale à 90°. Une fois l'accord obtenu à la fréquence F0, le filtre FP se comporte comme un fil ayant une tension de sortie V2 égale à la tension d'entrée V1 et une phase de sortie en quadrature avec la phase d'entrée (± 90°).

La précision de l'accord pouvant être obtenu est supérieure à celle que permet d'obtenir un simple tosmètre.

L'accord du circuit d'antenne 30 est assuré ici à intervalles réguliers par le dispositif embarqué TC2. Ce dispositif comprend essentiellement un circuit de mesure MC et un microprocesseur MP équipé d'une mémoire programme MEM.

Le circuit MC comprend deux circuits redresseurs MC1, MC2 et un circuit de mesure de différence de phase MC3. Le circuit MC1 reçoit en entrée la tension V1 et fournit un signal continu V1rms représentatif de l'amplitude de la tension V1. Le circuit MC2 reçoit en entrée la tension V2 et fournit un signal continu V2rms représentatif de l'amplitude de la tension V2. Le circuit MC3 reçoit en entrée les tensions V1 et V2 et un signal continu Vp représentatif de la différence de phase entre les tensions V1 et V2. Les signaux V1rms, V2rms et Vp sont appliqués au microprocesseur MP par l'intermédiaire d'un convertisseur analogique numérique ADC, qui fournit les signaux Sᵢ, Sⱼ décrits plus haut, assurant le contrôle des composants ajustables du sous-circuit d'antenne 20.

La figure 6 représente un exemple de réalisation du circuit MC1 ou MC2. La tension V1 ou V2 est appliquée, par l'intermédiaire d'une capacité de découplage Cd, sur la cathode d'une diode D1 polarisée en inverse ayant son anode connectée à la masse, ainsi que sur l'anode d'une diode D2 polarisée dans le sens passant. La cathode de la diode D2 est reliée à l'anode d'une capacité C1 dont la cathode est connectée à la masse, ainsi qu'à un pont diviseur de tension comprenant ici deux résistances R1, R2. La sortie du pont diviseur R1, R2 forme la sortie du circuit MC1 ou MC2 et fournit la tension V1rms ou V2rms.

La figure 7 illustre un exemple de réalisation du circuit MC3. La tension V1 est appliquée sur une première entrée d'une porte logique XOR ("ou exclusif") par l'intermédiaire d'une capacité de découplage Cd1 et d'une résistance série R3. La tension V2 est appliquée sur une deuxième entrée de la porte XOR par l'intermédiaire d'une capacité de découplage Cd2 et d'une résistance série R4. Par ailleurs, la première entrée de la porte XOR est polarisée en tension continue en étant connectée au point milieu d'un pont diviseur de tension comprenant deux résistances R5, R6 en série, la résistance R5 recevant une tension Vcc et la résistance R6 étant connectée à la masse. De même, la deuxième entrée de la porte XOR est polarisée en tension continue en étant connectée au point milieu d'un pont diviseur de tension comprenant deux résistances R7, R8 en série, la résistance R7 recevant la tension Vcc et la résistance R8 étant connectée à la masse. La porte XOR est alimentée par la tension Vcc et sa sortie fournit un signal Vx. Le signal Vx est appliqué à un filtre passe-bas comprenant par exemple une résistance série R9 et une capacité C2 dont la cathode est connectée à la masse. La sortie du filtre passe-bas fournit le signal Vp.

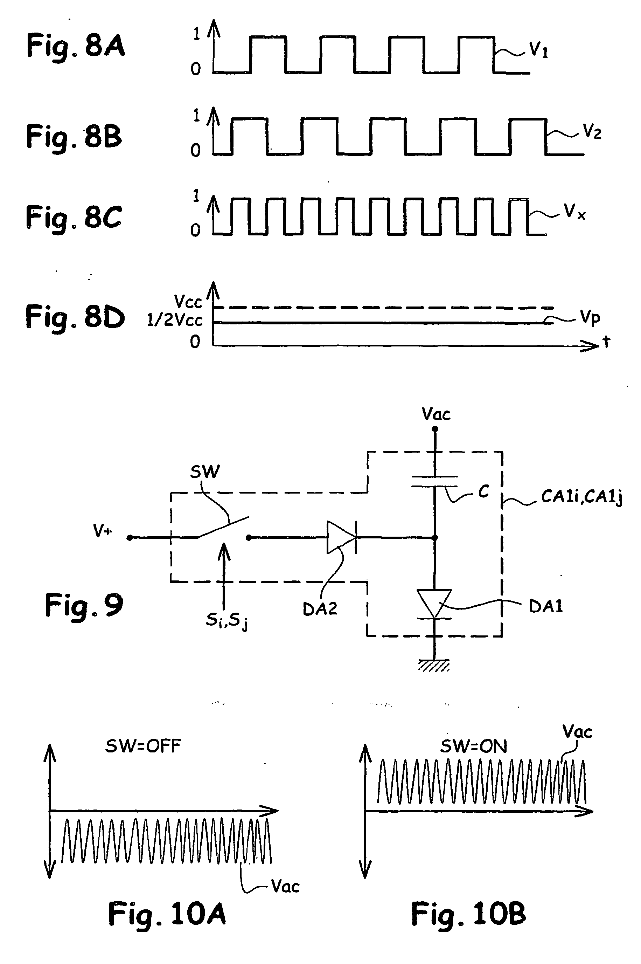

Les figures 8A à 8D représentent respectivement la forme des signaux V1, V2, Vx et Vp quand les tensions V1 et V2 sont déphasées de 90°. Les tensions V1, V2 telles qu'appliquées sur les entrées polarisées en tension continue de la porte XOR forment des signaux logiques. Ainsi la valeur basse des tensions V1, V2 (alternance négative) représente le "0" logique et la valeur haute (alternance positive) représente le "1" logique (Vcc). Les signaux V1, V2 étant en quadrature, le signal de sortie Vx est un signal logique de fréquence double de celle de V1, V2 présentant un rapport cyclique de 0,5. Dans ces conditions, le signal Vp est égal à 0,5 Vcc. Le signal Vp est égal à 0 lorsque les signaux V1, V2 sont en opposition de phase et est égal à Vcc lorsque ces signaux sont en phase.

Ainsi, la recherche par le microprocesseur d'une différence de phase de 90° entre V1 et V2 correspond ici à la recherche d'une valeur de Vp égale à 0,5 Vcc, soit la moitié de la valeur numérique pleine échelle Vpmax pouvant être fournie par le convertisseur ADC.

En résumé, l'accord du circuit d'antenne par le microprocesseur MP consiste ici à rechercher la bonne combinaison de signaux Si, Sj telle que
V1rms = V2rms
Vp= 0,5 Vpmax

Afin de simplifier le travail du microprocesseur MP et réduire le temps de recherche de la bonne combinaison de signaux Si, Sj, il est avantageux de charger dans la mémoire MEM une table de correspondance permettant au microprocesseur de trouver rapidement la combinaison recherchée à partir des valeurs V1rms, V2rms, Vp fournies par le circuit de mesure MC.

L'intervalle de temps séparant deux séquences d'accord de la fréquence de résonance du circuit d'antenne 30 peut être prédéterminé et sous le contrôle du microprocesseur MP. Les séquences d'accord peuvent aussi être sous le contrôle du lecteur RD qui envoie au microprocesseur MP un signal de recalage lorsqu'une séquence d'accord doit être conduite. Ce signal de recalage peut être implicite et consister par exemple en une interruption temporaire du signal d'excitation Se. Dans ce cas, le microprocesseur est programmé pour lancer une nouvelle séquence d'accord lorsque le signal d'excitation réapparaît.

Comme indiqué plus haut, le sous-circuit d'antenne 20 peut être réalisé conformément à la figure 2, c'est-à-dire en utilisant des relais RLᵢ, RLⱼ pour réaliser les composants commutables électriquement, généralement des capacités commutables CA1i, CA2j.

Toutefois des relais sont des dispositifs coûteux et encombrants qui peuvent générer dans le circuit d'antenne des parasites de commutation ainsi que des résistances parasites, pouvant entraîner avec le temps une atténuation du signal d'antenne et/ou un décalage de la fréquence de résonance.

Selon un aspect optionnel mais avantageux de la présente invention, les capacités commutables du circuit d'antenne sont réalisées au moyen d'interrupteurs statiques comme des transistors bipolaires ou des transistors MOS, et d'une diode de blocage.

La figure 9 représente un composant commutable CA1i, CA2j réalisé selon cette idée. Le composant comprend une capacité C dont la cathode est reliée à la masse par l'intermédiaire d'une diode DA1 au lieu d'être reliée à la masse par l'intermédiaire d'un relais électrique. Lorsque le circuit d'antenne reçoit le signal d'excitation Se, l'anode de la capacité C reçoit une tension alternative Vac.

La tension d'anode de la diode DA1 est contrôlée par un interrupteur statique SW, du type transistor MOS ou bipolaire, piloté par l'un des signaux Si ou Sj fournis par le microprocesseur. L'interrupteur SW reçoit sur une borne une tension continue V+ et son autre borne est reliée à l'anode de la diode DA1, par l'intermédiaire d'une diode DA2. La tension V+ est ainsi fournie par l'interrupteur SW lorsque celui-ci est dans l'état "ON", et est appliquée à l'anode de la diode DA1 via la diode DA2. Cette deuxième diode DA2 est agencée dans le sens passant relativement à la tension V+ et dans le sens bloqué relativement à la tension Vac, ce qui empêche celle-ci de remonter jusqu'à l'interrupteur SW.

A noter que tout autre composant passe-bas peut être prévu à la place de la diode DA2. Ainsi, par exemple, l'utilisation d'une self pour polariser et rendre passante la diode DA1 peut être préférée à l'utilisation de la diode DA2.

Lorsque le transistor-interrupteur SW est dans l'état OFF, la capacité C se charge et sa cathode présente une tension négative. La diode DA1 se bloque car les alternances de la tension Vac recopiées sur son anode sont en dessous du seuil de conduction de la diode DA1, comme illustré en figure 10A.

Lorsque l'interrupteur SW est dans l'état ON, la tension de polarisation V+ fait remonter la tension de l'anode de la diode DA1. La diode DA1 devient passante car les alternances de la tension Vac recopiées sur son anode via la capacité C sont au-dessus du seuil de conduction de la diode DA1, comme illustré en figure 10B.

Ainsi, la capacité commutable CA1i, CA2j selon l'invention est active dans le circuit d'antenne lorsque l'interrupteur SW est dans l'état ON, et est inactive dans le circuit d'antenne lorsque l'interrupteur SW est dans l'état OFF. L'interrupteur SW étant contrôlé par l'un des signaux Si ou Sj, la capacité commutable est l'équivalent d'une capacité commutée au moyen d'un relais, sans les inconvénients d'un relais.

Il apparaîtra clairement à l'homme de l'art que la présente invention est susceptible de diverses variantes de réalisation et applications.

Ainsi, le procédé selon l'invention peut ne comprendre qu'une mesure de l'une des tensions V1, V2 sans mesure de phase si l'amplitude nominale Vnom du signal d'excitation Se est connue. Supposons à titre d'exemple que le signal d'excitation présente une amplitude nominale Vnom de 30V sur une charge de 50Ω. Tant que le circuit d'antenne n'est pas accordé la tension V1 à l'entrée du circuit d'antenne ou la tension V2 à la sortie du filtre n'est pas égale à 30V (on trouve par exemple V1 = 8V et V2 = 40V). Lorsque le circuit d'antenne est accordé, on trouve V1 = V2 = 30V car le filtre se comporte comme un fil de 50Ω.

D'autre part le procédé selon l'invention peut être mis en oeuvre avec d'autres types de filtre, passe-bas, passe-haut, passe-bande, en π, en T, etc. ayant de préférence des fréquences de coupure se situant en dessus ou en dessous de la fréquence d'accord visée F0, laquelle doit donc de préférence être comprise dans la bande passante du filtre.

D'autre part le terme de "filtre" est nullement limitatif dans le contexte de la présente invention et peut désigner tout type d'élément, par exemple un déphaseur accordé, ayant une impédance et une phase déterminée à la fréquence d'accord visée. Cet élément intégré dans un circuit d'antenne selon l'invention est de préférence un élément LC sans élément résistif risquant d'atténuer le signal d'antenne, bien que des élément résistif de faible valeur puissent néanmoins être prévus pour diverses autres raisons.

Selon l'élément LC utilisé en tant que "filtre" au sens de l'invention, on peut obtenir des tensions V1, V2 ayant des amplitudes différentes et une différence de phase différente de 90° à la fréquence d'accord visée. Le rapport d'amplitude et la différence de phase des tensions V1, V2 sont ensuite utilisées comme valeurs de référence pour l'accord du filtre selon l'invention. Toutefois, l'avantage d'un filtre en π de type LC est d'offrir une différence de phase de 90° qui peut être détectée au moyen d'une simple porte OU EXCLUSIF, comme cela a été décrit plus haut.

D'autre part, bien que l'on ait proposé ci-dessus de prévoir un dispositif embarqué TC2 assurant automatiquement l'accord du circuit d'antenne 30, le procédé de l'invention peut également être mis en oeuvre manuellement sur un circuit d'antenne comprenant des composants ajustables manuellement. Quelles que soient les modalités de sa mise en oeuvre, le procédé de l'invention offre l'avantage de permettre un accord précis d'un circuit d'antenne sans nécessiter des moyens de mesure complexes comme des analyseurs d'impédance et de phase.

## Revendications

1. Circuit d'antenne (30) accordable sur une fréquence de résonance déterminée (F0), comprenant une bobine d'antenne (L) et des composants ajustables (CA1, CA2), **caractérisé en ce qu'**il comprend un filtre (FP) faisant partie intégrante du circuit d'antenne et présentant au moins un point (P1, P2) de prélèvement d'une tension électrique (V1, V2) dont l'amplitude forme une information pertinente pour l'accord du circuit d'antenne.

2. Circuit d'antenne selon la revendication 1, dans lequel le filtre est agencé à l'entrée du circuit d'antenne.

3. Circuit d'antenne selon l'une des revendications 1 et 2, dans lequel le filtre présente une structure en π.

4. Circuit d'antenne selon l'une des revendications 1 à 3, dans lequel le filtre est un élément LC.

5. Circuit d'antenne selon l'une des revendications 1 à 4, dans lequel le filtre comprend une inductance série (LF) et deux capacités (CF1, CF2) en parallèle.

6. Circuit d'antenne selon l'une des revendications 1 à 5, comprenant un circuit de mesure embarqué (MC) connecté au filtre (FP) au moins au point (P1, P2) de prélèvement de la tension électrique (V1, V2).

7. Circuit d'antenne selon l'une des revendications 1 à 6, dans lequel le filtre présente deux points (P1, P2) de prélèvement de deux tensions électriques (V1, V2) dont le rapport d'amplitude forme une information pertinente pour l'accord du circuit d'antenne.

8. Circuit d'antenne selon la revendication 7, comprenant un circuit de mesure embarqué (MC) connecté aux deux points (P1, P2) de prélèvement des deux tensions électriques (V1, V2).

9. Circuit d'antenne selon la revendication 8, dans lequel le circuit de mesure comprend des moyens (MC1, MC2) de mesure d'amplitude fournissant deux signaux (V1rms, V2rms) en tension ou en courant continu proportionnels à l'amplitude des tensions électriques (V1, V2).

10. Circuit d'antenne selon l'une des revendications 8 et 9, dans lequel le circuit de mesure comprend des moyens (MC3) de mesure de la différence de phase entre les deux tensions électriques (V1, V2).

11. Circuit d'antenne selon la revendication 10, dans lequel les moyens (MC3) de mesure de la différence de phase fournissent un signal (Vp) en tension ou en courant continu qui est proportionnel à la différence de phase entre les deux tensions électriques (V1, V2).

12. Circuit d'antenne selon la revendication 11, dans lequel les moyens (MC3) de mesure de la différence de phase comprennent une porte logique (XOR) recevant en entrée des signaux issus des deux tensions électriques (V1, V2), et des moyens (R9, C2) pour fournir un signal (Vp) en tension ou en courant continu proportionnel au rapport cyclique d'un signal (Vx) fourni par la porte logique.

13. Circuit d'antenne selon l'une des revendications 7 à 12, comprenant un dispositif d'accord embarqué (TC2) agencé pour ajuster les composants ajustables du circuit d'antenne de manière que les deux tensions électriques (V1, V2) présentent un rapport d'amplitude déterminé.

14. Circuit d'antenne selon la revendication 13, dans lequel le dispositif d'accord (TC2) est agencé pour ajuster les composants ajustables du circuit d'antenne de manière que les deux tensions électriques (V1, V2) aient la même amplitude.

15. Circuit d'antenne selon l'une des revendications 13 et 14, dans lequel le dispositif d'accord embarqué (TC2) est agencé pour ajuster les composants ajustables du circuit d'antenne de manière que les deux tensions électriques (V1, V2) présentent également une différence de phase déterminée.

16. Circuit d'antenne selon la revendication 15, dans lequel le dispositif d'accord (TC2) est agencé pour ajuster les composants ajustables du circuit d'antenne de manière que les deux tensions électriques (V1, V2) présentent une différence de phase de 90°.

17. Circuit d'antenne selon l'une des revendications 13 à 16, dans lequel le dispositif d'accord comprend un microprocesseur (MP) recevant un premier signal (V1rms) représentatif de l'amplitude de l'une des deux tensions électriques, un second signal (V2rms) représentatif de l'amplitude de l'autre tension électrique, et un troisième signal (Vp) représentatif de la différence de phase entre les deux tensions électriques, le microprocesseur fournissant au circuit d'antenne des signaux (Si, Sj) de contrôle des composants ajustables.

18. Circuit d'antenne selon l'une des revendications 13 à 17 dans lequel, pendant l'accord du circuit d'antenne par le dispositif d'accord, le circuit d'antenne reçoit un signal d'excitation (Se) fourni par un lecteur de circuit intégré sans contact.

19. Circuit d'antenne selon l'une des revendications 1 à 18, dans lequel les composants ajustables comprennent des capacités commutables électriquement (CA1, CA2).

20. Circuit d'antenne selon l'une des revendications 1 à 19, comprenant des composants ajustables comportant chacun une capacité (C), une diode (DA1) connectée à la cathode de la capacité, et un transistor interrupteur (SW) pour appliquer ou ne pas appliquer une tension de polarisation (V+) à l'anode de la diode (DA1), de manière que la capacité soit active ou inactive dans le circuit d'antenne.

21. Lecteur de circuit intégré sans contact, comprenant un circuit d'antenne selon l'une des revendications 1 à 20.

22. Procédé pour accorder sur une fréquence de résonance déterminée (F0) un circuit d'antenne (30) comprenant une bobine d'antenne (L) et des composants ajustables (CA1, CA2), **caractérisé en ce qu'**il comprend les étapes consistant à :
- incorporer un filtre (FP) dans le circuit d'antenne (30) de manière que le filtre fasse partie intégrante du circuit d'antenne,
- appliquer un signal d'excitation (Se) au circuit d'antenne,
- prélever au moins une première tension électrique (V1, V2) sur une borne (P1, P2) du filtre ,
- ajuster les composants ajustables (CA1, CA2) du circuit d'antenne de manière que la première tension électrique (V1, V2) présente une amplitude déterminée.

23. Procédé selon la revendication 22, comprenant les étapes consistant à :
- prélever une deuxième tension électrique (V1, V2) sur une autre borne (P1, P2) du filtre ,
- ajuster les composants ajustables (CA1, CA2) du circuit d'antenne de manière que les deux tensions électriques présentent un rapport d'amplitude déterminé.

24. Procédé selon la revendication 23, dans lequel les composants ajustables (CA1, CA2) du circuit d'antenne sont ajustés de manière que les deux tensions électriques (V1, V2) aient la même amplitude.

25. Procédé selon l'une des revendications 23 et 24, dans lequel les composants ajustables (CA1, CA2) du circuit d'antenne sont ajustés de manière que les deux tensions électriques (V1, V2) présentent également une différence de phase déterminée.

26. Procédé selon la revendication 25, dans lequel les composants ajustables du circuit d'antenne sont ajustés de manière que les deux tensions électriques (V1, V2) présentent une différence de phase de 90°.

27. Procédé selon l'une des revendications 23 à 26, dans lequel les deux tensions électriques sont mesurées au moyen d'un circuit de mesure embarqué (MC) relié au filtre de façon permanente.

28. Procédé selon l'une des revendications 22 à 27, dans lequel le filtre est agencé à l'entrée du circuit d'antenne.

29. Procédé selon l'une des revendications 22 à 28, dans lequel le filtre présente une structure en π.

30. Procédé selon l'une des revendications 22 à 29, dans lequel le filtre est un élément LC.

31. Procédé selon les revendications 22 à 30, dans lequel le filtre comprend une inductance série (L) et deux capacités (CF1, CF2) en parallèle.

32. Procédé selon l'une des revendications 22 à 31, dans lequel l'accord du circuit d'antenne est réalisé au moyen d'un dispositif d'accord embarqué (TC2) relié au filtre de façon permanente.

33. Procédé selon la revendication 32, dans lequel l'accord du circuit d'antenne est réalisé au moyen d'un dispositif d'accord embarqué (TC2) comprenant un microprocesseur programmé pour accorder cycliquement le circuit d'antenne.

34. Procédé selon l'une des revendications 22 à 33, dans lequel le circuit d'antenne reçoit pendant son accord un signal d'excitation (Se) fourni par un lecteur (RD) de circuit intégré sans contact.

35. Procédé selon l'une des revendications 22 à 34, dans lequel les composants ajustables du circuit d'antenne comprennent des capacités commutables électriquement (CA1, CA2).

36. Procédé selon l'une des revendications 22 à 35, dans lequel l'accord du circuit d'antenne est réalisé au moyen de composants ajustables comprenant chacun une capacité (C), une diode (DA1) connectée à la cathode de la capacité, et un transistor interrupteur (SW) pour appliquer ou ne pas appliquer une tension de polarisation (V+) à l'anode de la diode (DA1), de manière que la capacité soit active ou inactive dans le circuit d'antenne.

## Claims

1. An antenna circuit (30) tunable to a determined resonance frequency (F0), comprising an antenna coil (L) and adjustable components (CA1, CA2), **characterised in that** it comprises a filter (FP) that is an integral part of the antenna circuit and having at least one point (P1, P2) for tapping an electric voltage (V1, V2) the amplitude of which forms a pertinent indication for tuning the antenna circuit.

2. Antenna circuit according to claim 1, wherein the filter is arranged at the input of the antenna circuit.

3. Antenna circuit according to one of claims 1 and 2, wherein the filter has a structure in π.

4. Antenna circuit according to one of claims 1 to 3, wherein the filter is an LC element.

5. Antenna circuit according to one of claims 1 to 4, wherein the filter comprises a series inductor (LF) and two capacitors (CF1, CF2) in parallel.

6. Antenna circuit according to one of claims 1 to 5, comprising an embedded measuring circuit (MC) connected to the filter (FP) at least at the point (P1, P2) for tapping the electric voltage (V1, V2).

7. Antenna circuit according to one of claims 1 to 6, wherein the filter has two points (P1, P2) for tapping two electric voltages (V1, V2) the amplitude ratio of which forms a pertinent indication for tuning the antenna circuit.

8. Antenna circuit according to claim 7, comprising an embedded measuring circuit (MC) connected to the two points (P1, P2) for tapping the two electric voltages (V1, V2).

9. Antenna circuit according to claim 8, wherein the measuring circuit comprises amplitude measuring means (MC1, MC2) supplying two voltage or direct current signals (V1rms, V2rms) proportional to the amplitude of the electric voltages (V1, V2).

10. Antenna circuit according to one of claims 8 and 9, wherein the measuring circuit comprises means (MC3) for measuring the phase difference between the two electric voltages (V1, V2).

11. Antenna circuit according to claim 10, wherein the means (MC3) for measuring the phase difference supply a voltage or direct current signal (Vp) that is proportional to the phase difference between the two electric voltages (V1, V2).

12. Antenna circuit according to claim 11, wherein the means (MC3) for measuring the phase difference comprise a logic gate (XOR) receiving at input signals resulting from the two electric voltages (V1, V2), and means (R9, C2) for supplying a voltage or direct current signal (Vp) proportional to the duty cycle ratio of a signal (Vx) supplied by the logic gate.

13. Antenna circuit according to one of claims 7 to 12, comprising an embedded tuning device (TC2) arranged for adjusting the adjustable components of the antenna circuit so that the two electric voltages (V1, V2) have a determined amplitude ratio.

14. Antenna circuit according to claim 13, wherein the tuning device (TC2) is arranged for adjusting the adjustable components of the antenna circuit so that the two electric voltages (V1, V2) have the same amplitude.

15. Antenna circuit according to one of claims 13 and 14, wherein the embedded tuning device (TC2) is arranged for adjusting the adjustable components of the antenna circuit so that the two electric voltages (V1, V2) also have a determined phase difference.

16. Antenna circuit according to claim 15, wherein the tuning device (TC2) is arranged for adjusting the adjustable components of the antenna circuit so that the two electric voltages (V1, V2) have a phase difference of 90°.

17. Antenna circuit according to one of claims 13 to 16, wherein the tuning device comprises a microprocessor (MP) receiving a first signal (V1rms) representative of the amplitude of one of the two electric voltages, a second signal (V2rms) representative of the amplitude of the other electric voltage, and a third signal (Vp) representative of the phase difference between the two electric voltages, the microprocessor supplying to the antenna circuit signals (Si, Sj) for controlling the adjustable components.

18. Antenna circuit according to one of claims 13 to 17 wherein, during the tuning of the antenna circuit by the tuning device, the antenna circuit receives an excitation signal (Se) supplied by a contactless integrated circuit reader.

19. Antenna circuit according to one of claims 1 to 18, wherein the adjustable components comprise electrically switchable capacitors (CA1, CA2).

20. Antenna circuit according to one of claims 1 to 19, comprising adjustable components each comprising a capacitor (C), a diode (DA1) connected to the cathode of the capacitor, and a switch transistor (SW) for applying or not applying a bias voltage (V+) to the anode of the diode (DA1), so that the capacitor is active or inactive in the antenna circuit.

21. A contactless integrated circuit reader, comprising an antenna circuit according to one of claims 1 to 20.

22. A method for tuning to a determined resonance frequency (F0) an antenna circuit (30) comprising an antenna coil (L) and adjustable components (CA1, CA2), **characterised in that** it comprises the steps of:
- incorporating a filter (FP) into the antenna circuit (30) so that the filter is an integral part of the antenna circuit,
- applying an excitation signal (Se) to the antenna circuit,
- tapping at least a first electric voltage (V1, V2) at a terminal (P1, P2) of the filter,
- adjusting the adjustable components (CA1, CA2) of the antenna circuit so that the first electric voltage (V1, V2) has a determined amplitude.

23. Method according to claim 22, comprising the steps of:
- tapping a second electric voltage (V1, V2) at another terminal (P1, P2) of the filter,
- adjusting the adjustable components (CA1, CA2) of the antenna circuit so that the two electric voltages have a determined amplitude ratio.

24. Method according to claim 23, wherein the adjustable components (CA1, CA2) of the antenna circuit are adjusted so that the two electric voltages (V1, V2) have the same amplitude.

25. Method according to one of claims 23 and 24, wherein the adjustable components (CA1, CA2) of the antenna circuit are adjusted so that the two electric voltages (V1, V2) also have a determined phase difference.

26. Method according to claim 25, wherein the adjustable components of the antenna circuit are adjusted so that the two electric voltages (V1, V2) have a phase difference of 90°.

27. Method according to one of claims 23 to 26, wherein the two electric voltages are measured by means of an embedded measuring circuit (MC) permanently linked to the filter.

28. Method according to one of claims 22 to 27, wherein the filter is arranged at the input of the antenna circuit.

29. Method according to one of claims 22 to 28, wherein the filter has a structure in π.

30. Method according to one of claims 22 to 29, wherein the filter is an LC element.

31. Method according to claims 22 to 30, wherein the filter comprises a series inductor (L) and two capacitors (CF1, CF2) in parallel.

32. Method according to one of claims 22 to 31, wherein the tuning of the antenna circuit is performed by means of an embedded tuning device (TC2) permanently linked to the filter.

33. Method according to claim 32, wherein the tuning of the antenna circuit is performed by means of an embedded tuning device (TC2) comprising a microprocessor programmed for cyclically tuning the antenna circuit.

34. Method according to one of claims 22 to 33, wherein the antenna circuit receives during its tuning an excitation signal (Se) supplied by a contactless integrated circuit reader (RD).

35. Method according to one of claims 22 to 34, wherein the adjustable components of the antenna circuit comprise electrically switchable capacitors (CA1, CA2).

36. Method according to one of claims 22 to 35, wherein the tuning of the antenna circuit is performed by means of adjustable components each comprising a capacitor (C), a diode (DA1) connected to the cathode of the capacitor, and a switch transistor (SW) for applying or not applying a bias voltage (V+) to the anode of the diode (DA1), so that the capacitor is active or inactive in the antenna circuit.

## Patentansprüche

1. Antennenschaltung (30), die auf eine bestimmte Frequenz (F0) abstimmbar ist, umfassend eine Antennenspule (L) und justierbare Komponenten (CA1, CA2), **dadurch gekennzeichnet, dass** sie ein Filter (FP) umfasst, das ein integraler Bestandteil der Antennenschaltung ist und mindestens einen Punkt (P1, P2) zur Abnahme einer elektrischen Spannung (V1, V2) umfasst, deren Amplitude eine aussagekräftige Information zur Abstimmung der Antennenschaltung bildet.

2. Antennenschaltung nach Anspruch 1, in welcher das Filter am Eingang der Antennenschaltung angeordnet ist.

3. Antennenschaltung nach einem der Ansprüche 1 und 2, in welcher das Filter eine π-Struktur darstellt.

4. Antennenschaltung nach einem der Ansprüche 1 bis 3, in welcher das Filter ein LC-Element ist.

5. Antennenschaltung nach einem der Ansprüche 1 bis 4, in welcher das Filter eine Reiheninduktivität (LF) und zwei parallelgeschaltete Kapazitäten (CF1, CF2) umfasst.

6. Antennenschaltung nach einem der Ansprüche 1 bis 5, umfassend einen mitgeführten Messkreis (MC), der an ein Filter (FP) an mindestens einem Punkt (P1, P2) zur Abnahme der elektrischen Spannung (V1, V2) angeschlossen ist.

7. Antennenschaltung nach einem der Ansprüche 1 und 6, in welcher das Filter zwei Punkte (P1, P2) aufweist zur Abnahme von zwei elektrischen Spannungen (V1, V2), deren Amplitudenverhältnis eine aussagekräftige Information für die Abstimmung der Antennenschaltung bildet.

8. Antennenschaltung nach Anspruch 7, umfassend einen mitgeführten Messkreis (MC), der an den zwei Punkten (P1, P2) zur Abnahme der zwei elektrischen Spannungen (V1, V2) angeschlossen ist.

9. Antennenschaltung nach Anspruch 8, in welcher der Messkreis Mittel (MC1, MC2) zum Messen der Amplitude umfasst, wobei zwei Spannungs- oder Gleichstromsignale (V1rms, V2rms) proportional zur Amplitude der elektrischen Spannungen (V1, V2) bereitgestellt werden.

10. Antennenschaltung nach einem der Ansprüche 8 und 9, in welcher der Messkreis Mittel (MC3) zum Messen der Phasendifferenz zwischen den zwei elektrischen Spannungen (V1, V2) umfasst.

11. Antennenschaltung nach Anspruch 10, in welcher die Mittel (MC3) zum Messen der Phasendifferenz ein Spannungssignal (Vp) oder Gleichstromsignal bereitstellen, das proportional zur Phasendifferenz zwischen den zwei elektrischen Spannungen (V1, V2) ist.

12. Antennenschaltung nach Anspruch 11, in welcher die Mittel (MC3) zum Messen der Phasendifferenz einen logischen Torstromkreis (XOR) umfassen, der am Eingang Signale von den zwei elektrischen Spannungen (V1, V2) empfängt und Mittel (R9, C2), um ein Spannungssignal (Vp) oder Gleichstromsignal bereitzustellen, das proportional zum zyklischen Verhältnis eines Signals (Vx), welches vom logischen Torstromkreis bereitgestellt wird, ist.

13. Antennenschaltung nach einem der Ansprüche 7 bis 12, umfassend eine mitgeführte Abstimmungsvörrichtung (TC2), die zur Justierung der justierbaren Komponenten der Antennenschaltung in einer Weise angeordnet ist, dass die elektrischen Spannungen (V1, V2) ein bestimmtes Amplitudenverhältnis aufweisen.

14. Antennenschaltung nach Anspruch 13, in welcher die Abstimmungsvorrichtung (TC2) angeordnet ist, um die justierbaren Komponenten der Antennenschaltung in einer Weise zu justieren, dass die zwei elektrischen Spannungen (V1, V2) die gleiche Amplitude haben.

15. Antennenschaltung nach einem der Ansprüche 13 und 14, in welcher die mitgeführte Abstimmungsvorrichtung (TC2) angeordnet ist, um die justierbaren Komponenten der Antennenschaltung in einer Weise zu justieren, dass die zwei elektrischen Spannungen (V1, V2) auch eine bestimmte Phasendifferenz aufweisen.

16. Antennenschaltung nach Anspruch 15, in welcher die Abstimmungsvorrichtung (TC2) angeordnet ist, um die justierbaren Komponenten der Antennenschaltung in einer Weise zu justieren, dass die zwei elektrischen Spannungen (V1, V2) eine Phasendifferenz von 90° aufweisen.

17. Antennenschaltung nach einem der Ansprüche 13 bis 16, in welcher die Abstimmungsvorrichtung einen Mikroprozessor (MP) umfasst, der ein erstes Signal (V1rms) umfasst, das repräsentativ für die Amplitude einer der zwei elektrischen Spannungen ist, ein zweites Signal (V2rms), das repräsentativ für die Amplitude der anderen elektrischen Spannung ist und ein drittes Signal (Vp), das repräsentativ für die Phasendifferenz zwischen den zwei elektrischen Spannungen ist, wobei der Mikroprozessor der Antennenschaltung Signale (Si, Sj) zum Steuern der justierbaren Komponenten bereitstellt.

18. Antennenschaltung nach einem der Ansprüche 13 bis 17, in welcher die Antennenschaltung während der Abstimmung der Antennenschaltung durch die Abstimmungsvorrichtung ein Erregungssignal (Se) empfängt, das von einem kontaktlosen integrierten Lesegerät bereitgestellt wird.

19. Antennenschaltung nach einem der Ansprüche 1 bis 18, in welcher die justierbaren Komponenten elektrisch umschaltbare Kapazitäten (CA1, CA2) umfassen.

20. Antennenschaltung nach einem der Ansprüche 1 bis 19, umfassend justierbare Komponenten, die jeweils eine Kapazität (C) aufweisen, eine Diode (DA1), die an die Kathode der Kapazität angeschlossen ist und einen Schaltertransistor (SW), um eine Polarisationsspannung (V+) an der Anode der Diode (DA1) in einer Weise anzulegen oder nicht anzulegen, dass die Kapazität in der Antennenschaltung wirksam oder unwirksam ist.

21. Kontaktloses integriertes Lesegerät, umfassend eine Antennenschaltung nach einem der Ansprüche 1 bis 20.

22. Verfahren zur Abstimmung einer Antennenschaltung (30) auf eine bestimmte Resonanzfrequenz (F0), umfassend eine Antennenspule (L) und justierbare Komponenten (CA1, CA2), **dadurch gekennzeichnet, dass** es folgende Schritte umfasst:
- Einbinden eines Filters (FP) in die Antennenschaltung (30) in einer Weise, dass das Filter ein integraler Bestandteil der Antennenschaltung ist,
- Anlegen eines Erregungssignals (Se) an die Antennenschaltung,
- Abnehmen von mindestens einer ersten elektrischen Spannung (V1, V2) an einer Klemme (P1, P2) des Filters
- Justieren der justierbaren Komponenten (CA1, CA2) der Antennenschaltung in einer Weise, dass die erste elektrische Spannung (V1, V2) eine bestimmte Amplitude aufweist.

23. Verfahren nach Anspruch 22, umfassend die Schritte:
- Abnehmen einer zweiten elektrischen Spannung (V1, V2) auf einer anderen Klemme (P2, P2) des Filters,
- Justieren der justierbaren Komponenten (CA1, CA2) der Antennenschaltung in einer Weise, dass die zwei elektrischen Spannungen ein bestimmtes Amplitudenverhältnis aufweisen.

24. Verfahren nach Anspruch 23, in welchem die justierbaren Komponenten (CA1, CA2) der Antennenschaltung in einer Weise justiert werden, dass die zwei elektrischen Spannungen (V1, V2) die gleiche Amplitude haben.

25. Verfahren nach einem der Ansprüche Anspruch 23 und 24, in welchem die justierbaren Komponenten (CA1, CA2) der Antennenschaltung in einer Weise justiert werden, dass die zwei elektrischen Spannungen (V1, V2) auch eine bestimmte Phasendifferenz aufweisen.

26. Verfahren nach Anspruch 25, in welchem die justierbaren Komponenten der Antennenschaltung in einer Weise justiert werden, dass die zwei elektrischen Spannungen (V1, V2) eine Phasendifferenz von 90°aufweisen.

27. Verfahren nach einem der Ansprüche 23 bis 26, in welchem die zwei elektrischen Spannungen mittels eines mitgeführten Messkreises (MC), der dauernd an das Filter angeschlossen ist, gemessen werden.

28. Verfahren nach einem der Ansprüche 22 bis 27, in welchem das Filter am Eingang der Antennenschaltung angeordnet ist.

29. Verfahren nach einem der Ansprüche 22 bis 28, in welchem das Filter eine π-Struktur aufweist.

30. Verfahren nach einem der Ansprüche 22 bis 29, in welchem das Filter ein LC-Element ist.

31. Verfahren nach einem der Ansprüche 22 bis 30, in welchem das Filter eine Reiheninduktivität (LF) und zwei parallelgeschaltete Kapazitäten (CF1, CF2) umfasst.

32. Verfahren nach einem der Ansprüche 22 bis 31, in welchem die Abstimmung der Antennenschaltung mittels einer mitgeführten Abstimmungsvorrichtung (TC2), die dauernd an das Filter angeschlossen ist, ausgeführt wird.

33. Verfahren nach Anspruch 32, in welchem die Abstimmung der Antennenschaltung mittels einer mitgeführten Abstimmungsvorrichtung (TC2), die einen programmierten Mikroprozessor zur zyklischen Abstimmung der Antennenschaltung umfasst, ausgeführt wird.

34. Verfahren nach einem der Ansprüche 22 bis 33, in welchem die Antennenschaltung während ihrer Abstimmung ein Erregungssignal (Se) empfängt, das von einem kontaktlosen integrierten Lesegerät (RD) bereitgestellt wird.

35. Verfahren nach einem der Ansprüche 22 bis 34, in welchem die justierbaren Komponenten der Antennenschaltung elektrisch umschaltbare Kapazitäten (CA1, CA2) umfassen.

36. Verfahren nach einem der Ansprüche 22 bis 35, in welchem die Abstimmung der Antennenschaltung mittels justierbarer Komponenten ausgeführt wird, die jeweils eine Kapazität (C) aufweisen, eine Diode (DA1), die an die Kathode der Kapazität angeschlossen ist und einen Schaltertransistor (SW), um eine Polarisationsspannung (V+) an der Anode der Diode (DA1) in einer Weise anzulegen oder nicht anzulegen, dass die Kapazität in der Antennenschaltung wirksam oder unwirksam ist.
